# EUROPEAN PATENT APPLICATION

(11) **EP 1 120 902 A2**
(43) Date of publication of application: **01.08.2001**
(21) Application number: 00117465.5
(22) Date of filing: 11.08.2000
(51) Int. Cl.: H03F 1/02

(54) **Transmitter and mobile station**

(30) Priority: 18.01.2000 JP 2000013976
(71) Applicant: Kokusai Electric Co., Ltd., Tokyo 164-8511 (JP)
(72) Inventor: Takada, Toshio, c/o Kokusai Electric Co.,Ltd., Tokyo 164-8511 (JP)
(74) Representative: Grünecker, Kinkeldey, Stockmair & Schwanhäusser Anwaltssozietät

(57) **Abstract**

A transmitter for transmitting a transmission signal, which is an object to be transmitted, by radio transmission has: a plurality of analog signal output units (140, 141), each of which outputs an analog signal based on a predetermined condition of the transmitter; an analog signal selecting unit (145) that selects at least one of the plurality of the analog signals output from the plurality of analog signal output units (140, 141); and an analog/digital converter (146) that converts the at least one of analog signals, which is selected by the analog signal selecting unit (145), to a digital signal.

## Description

### BACKGROUND OF THE INVENTION

### 1. Field of the Invention

The present invention relates to a transmitter and a mobile station that transmits a signal by radio transmission.

### 2. Description of the Related Art

Conventionally, a radio transmitter-receiver comprises an amplifier, which amplifies and attenuates a power level of transmission of a signal by the amplifier.

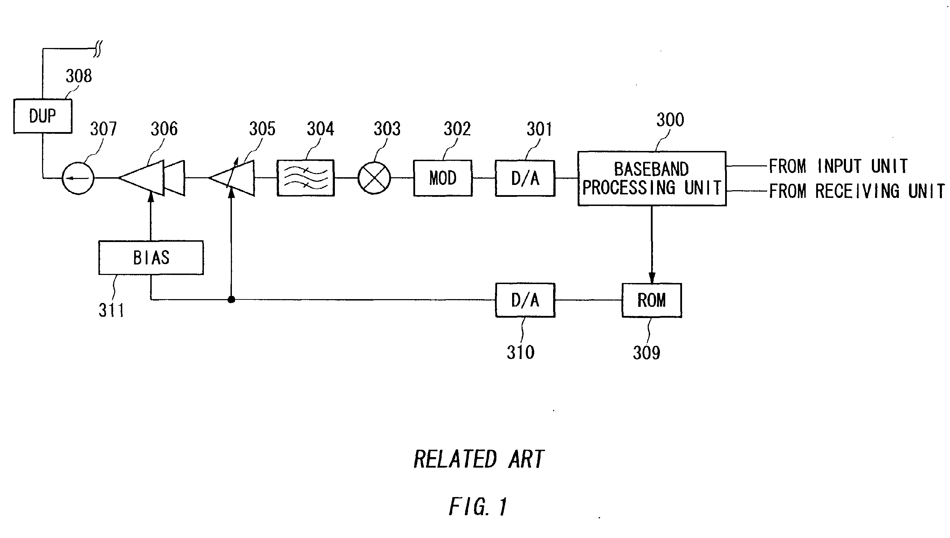

Fig. 1 shows a configuration of the conventional transmitter-receiver. In this transmitter-receiver, a voice signal, which is an object to be transmitted and is input from the input unit, not shown in the figure, is input to a baseband-processing unit 300. A predetermined process is applied to the voice signal by the baseband-processing unit 300. The processed signal is then converted to an analog signal by a digital/analog modulation unit 301 and then modulated to an intermediate frequency by a modulator 302.

Next, the modulated signal is converted to a radio frequency by a mixing unit 303, and unnecessary waves contained in the signal are then filtered by a band-pass filter 304. The filtered signal is then input to a variable gain amplifier 305 and a high power amplifier (PA) 306. Here, a baseband-processing unit 300 outputs target transmission power data to a ROM 309, which is data of transmission power to be targeted, based on a transmitter power control signal (TPC) output from a receiving unit, not shown in the figure. The ROM 309 outputs control data corresponding to target transmission power data input from the baseband-processing unit 300. A digital/analog converter 310 converts the control data input fromthebaseband-processingunit 300 to an analog signal and outputs the converted control data to a variable gain amplifier 305 and a bias control circuit 311.

Therefore, the variable gain amplifier 305 inputs the signal from the band-pass filter 304, whilst increasing and decreasing the gain based on the control data of the analog signal input from the digital/analog converter 310. The variable gain amplifier 305 sets the input signal to a predetermined power. The power amplifier 306 amplifies the signal input from the band-pass filter 304 to a transmission power, whilst maintaining high efficiency by controlling the bias according to the control data of the bias control circuit 311.

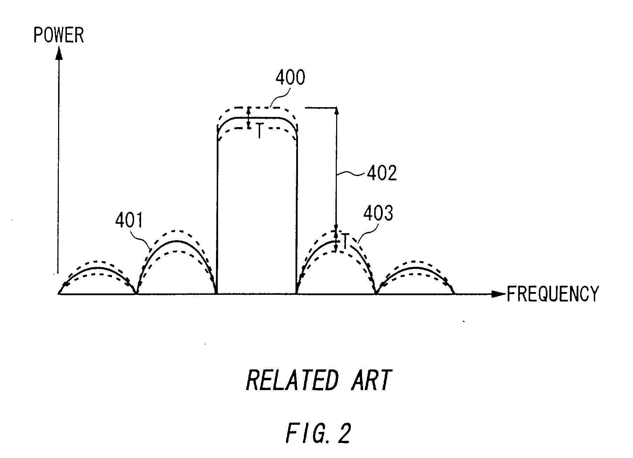

Fig. 2 shows a spectrum of a signal transmitted by the conventional transmitter-receiver. A spectrum of the signal to be transmitted includes a power component 400 of the desired wave and a power component 401, which is a wave leaked to an adjacent channel. Here, the difference 402 between the power value of the power component 400 of the desired wave and the power value of the power component 401 leaked to the adjacent channel is called an adjacent channel power ratio (ACPR) . Generally, it is necessary for the transmitter-receiver to maintain the ACPR above a predetermined reference value. The standard for maintaining the ACPR is stricter for a transmitter-receiver of a code division multiple access (CDMA) type.

The power value of the power component of the desired wave 400 and the power component leaked to the adjacent channel 401 fluctuate within the range, for example, shown by the broken line in Fig. 2, due to the temperature of the power amplifier 306. Therefore, the transmitter-receiver must always satisfy the ACPR standard under a temperature which guarantees the operation of the power amplifier 306.

The conventional means of controlling the power amplifier is shown below. In the Japanese Patent Application Laid-Open No. H5-83041, an amplifier constituted by a field-effect transistor has a gate bias control circuit that controls a gate voltage based on the gate voltage data read out from the storing means, which stores the gate voltage data.

In the Japanese Patent Application Laid-Open No. H8-222963, a power amplifying circuit that amplifies the power of a high frequency signal has a transmission power control circuit that includes a relation table, which registers a transmission output control signal; a power-supply voltage, which is detected by the power supply voltage detecting circuit; and a most suitable direct current bias voltage, which is to be provided to the power amplifier and corresponds to the power-supply voltage. The transmission power control circuit determines the most suitable direct current bias voltage to be provided to the power amplifier, by retrieving the relation table based on the transmission output control signal and the power supply voltage data, which are input to the transmission power control circuit.

In the Japanese Patent Application Laid-Open No. H8-330854, a temperature compensating circuit compensates for the temperature of the power amplifier by storing the data for each of the target powers for each temperature, measured when shipped from the factory, into the power control data memory, and by reading out the power control data corresponding to the temperature detecting data.

In the Japanese Patent No. 2738316, an FET power amplifier includes a power supply circuit that controls a bias voltage of a drain terminal of an FET amplifier. The FET power amplifier controls the power supply circuit to supply the bias voltage, which can optimize the efficiency of the whole FET power amplifier, based on an output of a temperature sensor provided nearby the FET amplifier.

Moreover, the conventional radio transmitter-receiver comprises a plurality of components which output an analog signal, such as a temperature sensor that detects a temperature, and a voltage sensor that detects a voltage of a power supply. The transmitter-receiver performs various kinds of controls by converting the analog signal shown above to a digital signal.

As shown above, it is requested to the radio transmitter-receiver to efficiently perform the power amplification using the power amplifier. Particularly for a portable radio transmitter-receiver, the available time of the radio transmitter-receiver becomes short if the efficiency of the power amplifier is low. Furthermore, it is requested to reduce the cost of manufacturing the radio transmitter-receiver. It is also requested to reduce the size and weight of the radio transmitter-receiver. Reducing the size and weight of the transmitter-receiver is an especially important matter for a radio transmitter-receiver which is used portably.

### SUMMARY OF THE INVENTION

Therefore, it is an object of the present invention to provide a transmitter which overcomes the above issues in the related art. This object is achieved by combinations described in the independent claims. The dependent claims define further advantageous and exemplary combinations of the present invention.

According to the first aspect of the present invention, a transmitter for transmitting a transmission signal, which is an object to be transmitted, by radio transmission can be provided. The transmitter comprises: a plurality of analog signal output units, each of which outputs an analog signal based on a predetermined condition of the transmitter; an analog signal selecting unit that selects at least one of the plurality of analog signals output from the plurality of analog signal output units; and an analog/digital converter that converts the at least one analog signal, which is selected by the analog signal selecting unit, to a digital signal.

The transmitter may further comprise: a power amplifier that amplifies the transmission signal based on a bias signal, which adjusts a power of the transmission signal wherein one of the analog signal output units outputs the analog signal based ona temperature of the power amplifier; the analog/digital converter converts the analog signal output to a digital signal based on the temperature of the power amplifier; and a bias signal output unit that outputs a bias signal based on at least one of the digital signal, power control data that determines a target power to which a power of the transmission signal is to be amplified, and a transmission frequency for transmitting the transmission signal.

The bias signal output unit may store the bias signal, which corresponds to each of the digital signals, the transmission frequency, and the power control data, and may output the bias signal based on at least one of the digital signal, the transmission frequency, and the power control data. The transmitter may further comprise: a register that stores the digital signal converted from the analog signal by the analog/digital converter, which is output based on the temperature of the power amplifier; wherein the bias signal output unit outputs the bias signal based on the digital signal stored in the register.

The analog signal selecting unit may select the analog signal from the plurality of analog signals one after another at a predetermined time interval. The transmitter may further comprise: a battery for supplying power; and a power amplifier that amplifies the transmission signal based on a bias signal, which adjusts a power of the transmission signal wherein one of the analog signal output units outputs the analog signal based on a voltage of the battery, and the analog/digital converter converts the analog signal, which is output based on the voltage of the battery, to a digital signal; and an abnormality detector which detects abnormality of the battery based on the digital signal, when the voltage of the battery is out of a permissible range.

The transmitter may further comprise a register that stores the digital signal converted from the analog signal, which is output based on the voltage of the battery, by the analog/digital converter; wherein, the abnormality detector detects abnormality of the battery based on the digital signal stored in the register.

The transmitter may further comprise: a battery for supplying power; and a power amplifier that amplifies the transmission signal based on a bias signal, which adjusts the power of the transmission signal wherein one of the analog signal output units outputs an analog signal based on a temperature of the battery, and the analog/digital converter converts the analog signal, which is output based on the temperature of the battery, to a digital signal; and an abnormality detector which detects abnormality of the battery based on the digital signal, when the temperature of the battery is out of a permissible range.

The transmitter may further comprise : a register which stores the digital signal converted from the analog signal, which is output based on the temperature of the battery, by the analog/digital converter; wherein the abnormality detector detects abnormality of the battery based on the digital signal stored in the register.

According to the second aspect of the present invention, a mobile station for a radio communication system can be provided. The mobile station may comprise: an antenna which receives and transmits a signal; a receiving unit which converts a frequency of the signal received by the antenna to a predetermined intermediate frequency; a baseband processing unit which demodulates the signal input from the receiving unit to obtain data contained in the signal and modulates a transmission signal, which is a signal to be transmitted; an input/output unit which outputs the data obtained by the baseband processing unit and inputs data, which is to be transmitted, from outside, to output the transmission signal to the baseband processing unit; a plurality of analog signal output units, each of which outputs an analog signal based on a predetermined condition of the mobile station; an analog signal selecting unit that selects at least one of the plurality of the analog signals output from the plurality of analog signal output units; an analog/digital converter that converts the at least one analog signal, which is selected by the analog signal selecting unit, to a digital signal; and a transmitting unit which converts a frequency of the transmission signal modulated by the baseband processing unit to a predetermined frequency and outputs the transmission signal to the antenna, based on the digital signal converted by the analog/digital converter.

The transmitting unit may include a power amplifier that amplifies the transmission signal based on a bias signal, which adjusts a power of the transmission signal; one of the analog signal output units outputs the analog signal based on a temperature of the power amplifier; the analog/digital converter converts the analog signal, which is output based on the temperature of the poweramplifier, toadigital signal . The mobile station may further comprise a bias signal output unit that outputs the bias signal based on at least one of the digital signal, power control data that determines a target power, to which a power of the transmission signal is to be amplified, and a transmission frequency for transmitting the transmission signal. The analog signal selecting unit may select the analog signal from the plurality of analog signals one after another, at a predetermined time interval.

According to the third aspect of the present invention, a method for transmitting a transmission signal, which is an object to be transmitted, by radio transmission can be provided. The method may include: outputting a plurality of analog signals based on a predetermined condition of transmitting the transmission signal; selecting at least one of the plurality of analog signals output by the outputting; and converting at least one of the analog signals, which is selected by the selecting, to a digital signal.

The method may further include: amplifying the transmission signal based on a bias signal, which adjusts a power of the transmission signal wherein the outputting outputs the analog signal based on a temperature caused by the amplifying and the converting converts the analog signal, which is output based on the temperature, to the digital signal; and outputting the bias signal based on at least one of the digital signal, power control data that determines a target power to which a power of the transmission signal is amplified, and a transmission frequency for transmitting the transmission signal.

The method may further include: storing the digital signal converted from the analog signal, which is output based on the temperature caused by the amplifying; wherein outputting the bias signal outputs the bias signal based on the digital signal stored by the storing. The selecting may select the analog signal from the plurality of analog signals one after another, at a predetermined time interval.

The method may further include: supplying power from a battery; amplifying the transmission signal based on a bias signal, which adjusts a power of the transmission signal wherein the outputting outputs the analog signal based on a voltage of the battery, and the converting converts the analog signal, which is output based on the voltage of the battery, to the digital signal; and detecting abnormality of the batterybased on the digital signal, when the voltage of the battery is out of a permissible range.

The method may further include: storing the digital signal converted from the analog signal, which is output based on the voltage of the battery; wherein, the detecting detects abnormality of the battery based on the digital signal stored by the storing.

The method may further include: supplying power from a battery; amplifying the transmission signal based on a bias signal, which adjusts the power of the transmission signal wherein the outputting outputs the analog signal based on a temperature of the battery and the converting converts the analog signal, which is output based on the temperature of the battery, to the digital signal; and detecting abnormality of the battery based on the digital signal, when the temperature of the battery is out of a permissible range.

The method may further include: storing the digital signal converted from the analog signal, which is output based on the temperature of the battery; wherein the detecting detects abnormality of the battery based on the digital signal stored by the storing.

This summary of the invention does not necessarily describe all necessary features of the present invention. The present invention may also be a sub-combination of the above described features. The above and other features and advantages of the present invention will become more apparent from the following description of embodiments taken in conjunction with the accompanying drawings.

### BRIEF DESCRIPTION OF THE DRAWINGS

Fig. 1 shows a configuration of the conventional transmitter-receiver.

Fig. 2 shows a spectrum of a signal transmitted by the conventional transmitter-receiver.

Fig. 3 shows a configuration of a communication system including a mobile station according to the first embodiment of the present invention.

Fig. 4 shows a part of a configuration of the mobile station according to the first embodiment of the present invention.

Fig. 5 shows an example of the temperature sensor 140 according to the first embodiment.

Fig. 6 shows another embodiment of the temperature sensor according to the first embodiment of the present invention.

Fig. 7 shows an example of the configuration of the power amplifier 126 and the arrangement of the temperature sensor 140 according to the first embodiment of the present invention.

Fig. 8 shows another example of the arrangement of the temperature sensor 140 and the amplifier according to the first embodiment of the present invention.

Fig. 9 shows an outline of the storing condition of the ROM 129 according to the first embodiment of the present invention.

Fig. 10 shows another outline of the storing condition of the ROM 129 according to the first embodiment of the present invention.

Fig. 11 shows a further outline of the storing condition of the ROM 129 according to the first embodiment of the present invention.

Fig. 12 shows a flow chart that explains the operation of the mobile station according to the second embodiment of the present invention.

Fig. 13 shows a part of a configuration of a mobile station according to the third embodiment of the present invention.

### DETAILED DESCRIPTION OF THE INVENTION

The invention will now be described based on the preferred embodiments, which do not intend to limit the scope of the present invention, but exemplify the invention. All of the features and the combinations thereof described in the embodiment are not necessarily essential to the invention.

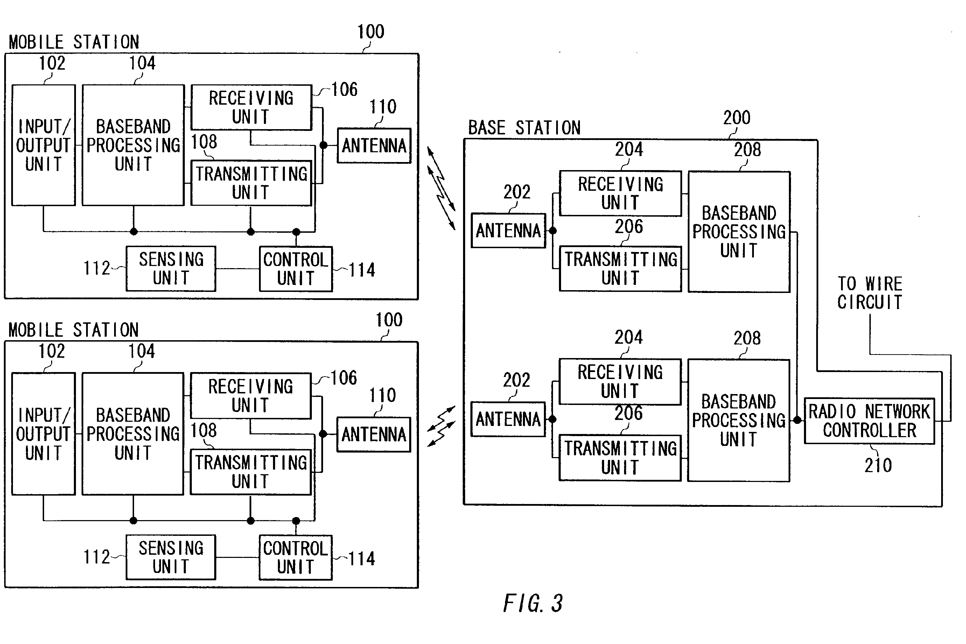

Fig. 3 shows a configuration of a communication system including a mobile station according to the first embodiment of the present invention. The communication system shown in Fig. 3 is a wide-band code division multiple access (W-CDMA) type communication system. This communication system has a base station 200 and a plurality of mobile stations 100. The base station 200 includes a plurality, in this case two in Fig. 3, of antennas 202, a plurality of receiving units 204, a plurality of transmitting units 206, a plurality of baseband-processing units 208, and a radio network controller 210.

The antenna 202 transmits a radio wave to the mobile station 100 and receives a radio wave from the mobile station 100. The receiving unit 204 detects a signal having a predetermined frequency from a radio wave received by the antenna 202, converts the frequency of the detected signal to a predetermined intermediate frequency and outputs the converted signal to the baseband-processing unit 208. Furthermore, the receiving unit 204 detects the power level of the received signal and notifies the power level to the baseband-processing unit 208. The transmitting unit 206 converts the signal, which is input from the baseband-processing unit 208, to a predetermined frequency.

The baseband-processing unit 208 performs despreading, chip synchronization, error-correction decoding, multi-isolation of data, and so on, on a signal, which is input from the receiving unit 204, to obtain transmitted data. Moreover, the baseband-processing unit 208 operates error-correction coding, framing, data modulating, and spread modulating on data to be transmitted, and outputs the data to the transmitting unit 206.

Moreover, the baseband-processing unit 208 generates transmission power control data for controlling transmission power of the mobile station 100 according to the power level of the signal notified from the receiving unit 204. In the present embodiment, the transmission power control data includes the information that indicates increasing or decreasing transmission power by 1 dB width. In the W-CDMA type communication system, the transmission power control data is transmitted from the transmitting unit 206 at 0.625 mm second intervals.

The transmission power control data related to the mobile station 100 is included in the data to be transmitted by the baseband-processing unit 208. The baseband-processing unit 208 outputs the signal in which the transmission power control data is included, and error-correction coding, framing, data modulating, and spread modulating are applied to the transmitting unit 206.

The radio network controller 210 controls the receiving unit 204, the transmitting unit 206, and a baseband-processing unit 208. Moreover, the radio network controller 210 outputs the data obtained by the baseband-processing unit 208 to the outside through the wire circuit. The radio network controller 210 also receives the data, which is an object to be transmitted, from the outside, and outputs the received data to the baseband-processing unit 208.

The mobile station 100 has an antenna 110, a receiving unit 106, a transmitting unit 108, a baseband-processing unit 104, an input/output unit 102, a sensing unit 112, and a control unit 114. The antenna 110 receives a radio wave from the base station 200 and transmits the radio wave to the base station 200. The receiving unit 106 detects a signal having a predetermined frequency from each of the signals received by the antenna 110, and converts the frequency of the signal to a predetermined intermediate frequency. Furthermore, the receiving unit 106 detects the received power of the received signal and outputs the received power to the baseband-processing unit 104. The transmitting unit 108 converts the frequency of the signal to be transmitted, to the predetermined frequency.

The baseband-processing unit 104 obtains the transmitted data by performing despreading, chip synchronizing, error-correction demodulating, and multi-isolating data, on the signal input from the receiving unit 106. Furthermore, the baseband-processing unit 104 takes out the transmission power control data included in the data and outputs the transmission power control data to the control unit 114. Moreover, the baseband-processing unit 104 outputs to the control unit 114, the value of the received power received from the receiving unit 106. The baseband-processing unit 104 notifies the transmission frequency to the control unit 114. The baseband-processing unit 104 also performs the error-correction coding, framing, data modulation, and spread modulation on the data, which is an object to be transmitted, and outputs to the transmitting unit 108.

The input/output unit 102 outputs to the outside, the data taken from the baseband-processing unit 104. In the present embodiment, the input/output unit 102 has a speaker, for example, and outputs the voice from the speaker based on the data. Furthermore, the input/output unit 102 receives the data to be transmitted from the outside and outputs the received data to the baseband-processing unit 104. In the present embodiment, the input/output unit 102 has a microphone and inputs data by receiving voice into the microphone. The control unit 114 controls the receiving unit 106, the transmitting unit 108, a baseband-processing unit 104, the input/output unit 102, and the sensing unit 112.

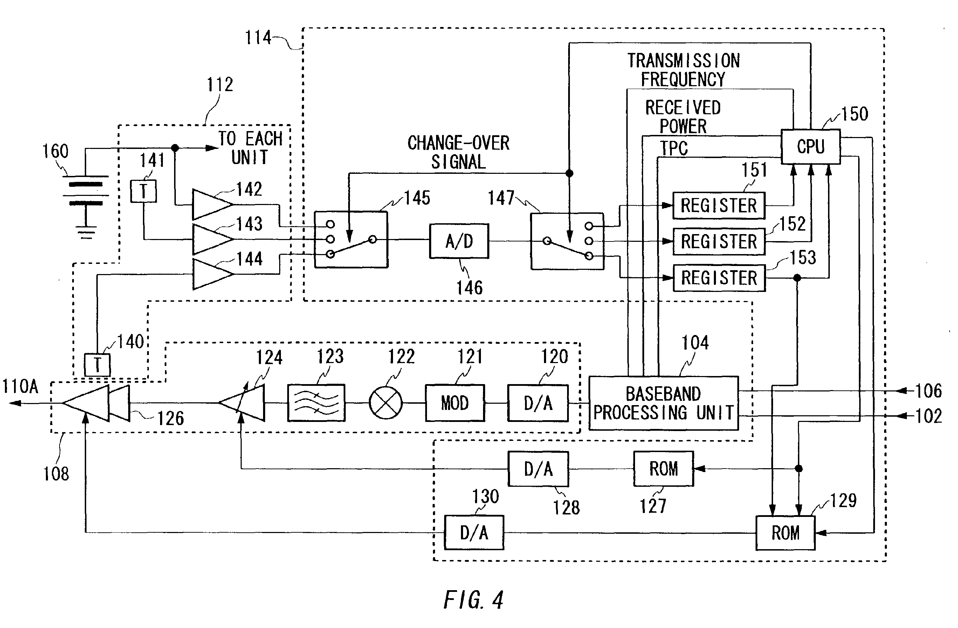

Fig. 4 shows a part of a configuration of the mobile station according to the first embodiment of the present invention. Fig. 4 shows the transmitting unit 108, the baseband-processing unit 104, the sensing unit 112, the control unit 114, and a power-supply battery 160 of the mobile station 100.

The sensing unit 112 has a temperature sensor 140, which is an example of a temperature sensor and an analog signal output unit; a temperature sensor 141, which is as an example of an analog signal output unit; and amplifiers 142, 143, and 144. The temperature sensor 140 is provided nearby the power amplifier 126 and outputs an analog signal based on the temperature of the power amplifier 126. The temperature sensor 141 is provided near by the power-source voltage 160 and outputs an analog signal based on the temperature of the power-supply battery 160.

The amplifier 142 amplifies an analog signal based on the voltage output from the power-source voltage 160 and outputs the analog signal to the change-over unit 145. The amplifier 143 amplifies the analog signal output from the temperature sensor 141 and outputs the amplified analog signal to the change-over unit 145. The amplifier 144 amplifies the analog signal output from the temperature sensor 140 and outputs the amplified analog signal to the change-over unit 145. Each of the amplifiers 142, 143, and 144 convert each of the voltages of the analog signals to a voltage suitable for the dynamic range of the analog/digital converter 146. In the present embodiment, because the dynamic range of the analog/digital converter 146 is from 0 to 3 V, the amplifier 144 is adjusted so that the maximum output voltage of the temperature sensor 140 corresponding to -20 degrees to plus 80 degrees becomes 3 V.

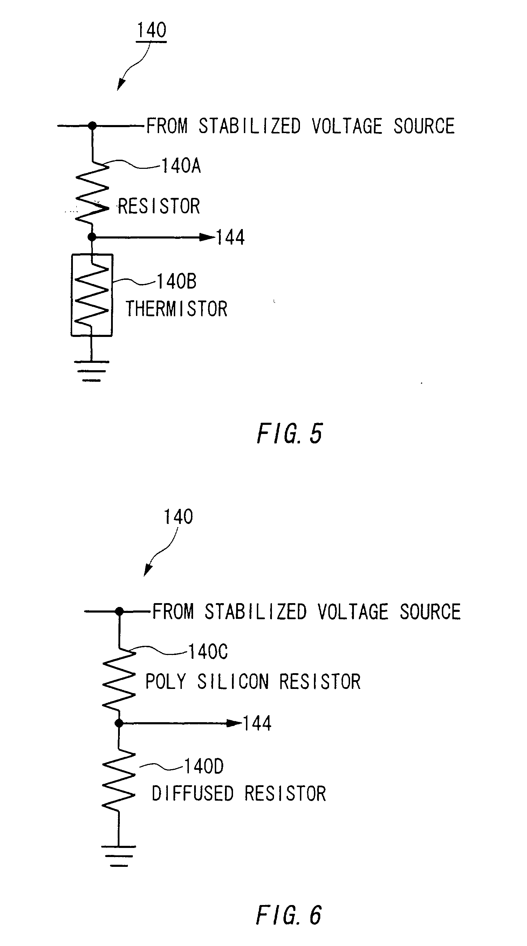

Fig. 5 shows an example of the temperature sensor 140 according to the first embodiment. The temperature sensor 140 has a resistor 140A and a thermistor 140B, the resistance of which changes with temperature. One of the terminals of the resistor 140A is connected to the stabilized voltage source, not shown in the figure, that supplies a constant voltage, and another terminal is connected to the thermistor 140B. Furthermore, the terminal of the thermistor 140B, which is not connected to the resistor 140A, is connected to earth. The terminal to which the resistor 140A and the thermistor 140B are connected, is connected to the amplifier 144. In the temperature sensor 140, the resistance of the thermistor 140B changes with the change of the nearby temperature, and the voltage corresponding to the resistance of the thermistor 140B is output to the amplifier 144. Therefore, the temperature nearby the temperature sensor 140 can be detected by the voltage output to the amplifier 144.

Fig. 6 shows another embodiment of the temperature sensor 140 according to the first embodiment of the present invention. The temperature sensor 140 has a poly silicon resistor 140C, and a diffused resistor 140D. Here, each of the resistances of the poly silicon resistor 140C and the resistor 140D change at a different ratio with the change of the temperature . Moreover, because the poly silicon resistor 140C and the diffused resistor 140D can be manufactured by an Integrated Circuit (IC) manufacturing process, the temperature sensor 140 can be constituted inside the IC chip.

One of the terminals of the poly silicon resistor 140C is connected to the stabilized voltage source, not shown in figure, that supplies a constant voltage, and another terminal is connected to the diffused resistor 140D. Moreover, the terminal of the diffused resistor 140D, which is not connected to the poly silicon resistor 140C, is connected to earth. The terminal to which the poly silicon resistor 140C and the diffused resistor 140D are connected, is connected to the amplifier 144. In the temperature sensor 140, the resistance of the poly silicon resistor 140C and the diffused resistor 140D changes with the change of the nearby temperature, and the voltage, which corresponds to the resistance of the poly silicon resistor 140C and the diffused resistor 140D, is output to the amplifier 144. Therefore, the temperature nearby the temperature sensor 140 can be detected by the voltage output to the amplifier 144.

Referring back to Fig. 4, the transmitting unit 108 has a digital/analog converter 120, a modulator 121, a mixing unit 122, a band-pass filter (BPF) 123, a variable gain amplifier 124, and a power amplifier 126. The digital/analog converter 120 receives from the baseband-processing unit 104, the data to be transmitted, and converts the received data to an analog signal. The modulation unit 121 modulates the frequency of the signal, which is converted to the analog signal, to an intermediate frequency. The mixing unit 122 converts a signal having an intermediate frequency, to a signal having a predetermined radio transmission frequency. The band-pass filter 123 filters unnecessary waves included in the signal. The variable gain amplifier 124 and the power amplifier 126 amplify the signal filtered by the band-pass filter 123.

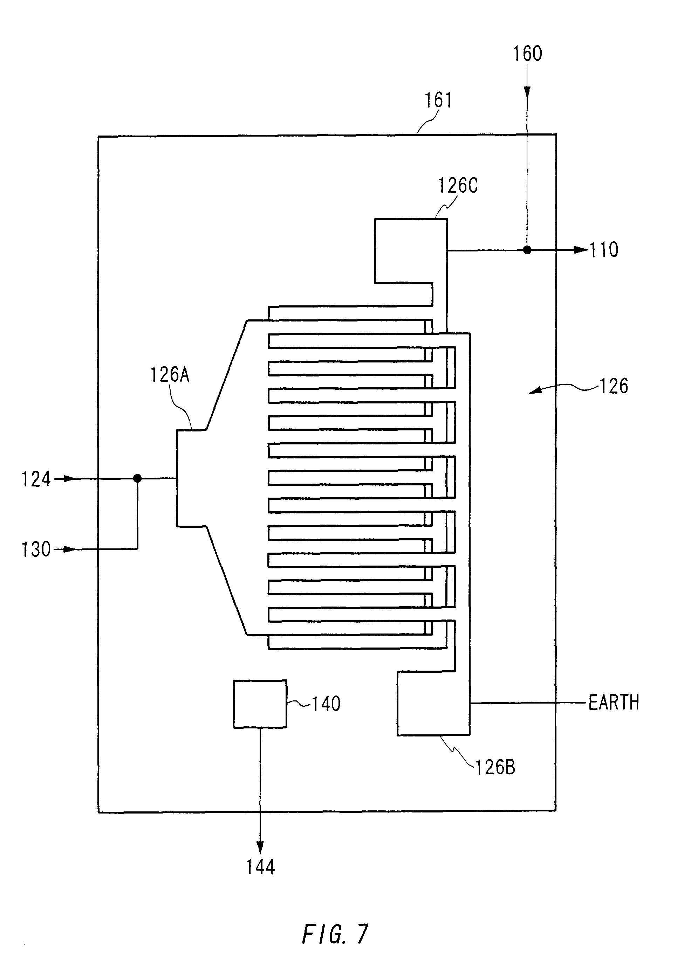

Fig. 7 shows an example of the configuration of the power amplifier 126 and the arrangement of the temperature sensor 140 according to the first embodiment of the present invention. The power amplifier 126 has a drain unit 126C, a source unit 126B, and a gate unit 126A. The gate unit 126A is connected to the variable gain amplifier 124 and the digital/analog converter 130. The drain unit 126C is connected to the power-supply battery 160 and the antenna 110. The source unit 126B is connected to earth. In the power amplifier 126, if the signal output from the variable gain amplifier 124 and the bias signal output from the digital/analog converter 130 are input to the gate unit 126A, an electric current having an amount corresponding to the voltage of the input signal and the bias signal flows from the drain unit 126C to the source unit 126B. Thereby, a signal having an amplified formof the signal input from the variable gain amplifier 124, is output from the power-supply battery 160 to the antenna 110. In this embodiment, the power amplifier 126 is formed as a chip 161, and the temperature sensor 140 is installed on the chip 161.

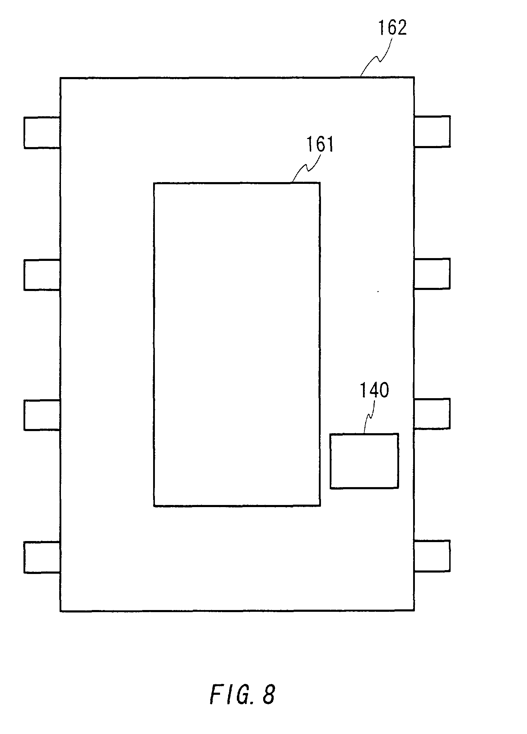

Fig. 8 shows another example of the arrangement of the temperature sensor 140 and the amplifier according to the first embodiment of the present invention. In Fig. 8, a power amplifier 126 is formed on a chip 161, and the chip 161 is included in the MMIC (Monolithic Microwave Integrated Circuit) 162. In this embodiment, the temperature sensor 140 is provided nearby the chip 161, inside the MMIC 162.

Referring back to Fig. 4, the control unit 114 has a change-over unit 145 as an example of an analog signal selecting unit; an analog/digital converter 146; a change-over unit 147; registers 151, 152, and 153; a CPU (Central Processing Unit) 150; a ROM (read only memory) 127; a digital/analog converterl28; a ROM 129 as an example of a bias signal output unit; and a digital/analog converter 130. The change-over unit 145 selects one of the analog signals input from the amplifiers 142, 143, and 144 according to the change-over signal input from the CPU 150, and outputs the selected analog signal to the analog/digital converter 146. Therefore, a plurality of analog signal can be converted to a digital signal without using a plurality of analog/digital converters. Thus the size of the transmitter-receiver can be reduced compared to the size of the conventional transmitter-receiver.

The analog/digital converter 146 converts the signal input from the change-over unit 145 to a digital signal. In this embodiment, the analog/digital converter 146 has a dynamic range from 0 V to 3 V and outputs 8 bit data for every 1 sampling. The change-over unit 147 outputs the data input from the analog/digital converter 146, to one of the registers 151, 152, and 153 according to the change-over signal input from the CPU 150.

In the present embodiment, the register 151 stores the data corresponding to the signal output from the amplifier 142, that is, the data related to the voltage of the power-supply battery 160, called the battery voltage data. The register 152 stores the data corresponding to the signal output from the amplifier 143, that is, the data related to the temperature of the power-supply battery 160, called the battery temperature data. The register 153 stores the data corresponding to the signal output from the amplifier 144, that is, the data related to the temperature of the power amplifier 126, called the amplifier temperature data. Furthermore, the register 153 outputs the stored amplifier temperature data to the ROM 129.

The CPU 150 outputs the change-over signal to the change-over units 145 and 147. In the present embodiment, the CPU 150 selects the signals output from the amplifiers 142, 143, and 144 one after another. The CPU 150 also outputs the change-over signal, which selects the registers 151, 152, and 153 that are the output destinations of the change-over unit 147, one after another, every 100 mm seconds, forexample. Therefore, in the present embodiment, the contents of the registers 151, 152, and 153 are updated every 200 mm seconds. In case there is a necessity for reflecting the temperature data of the power amplifier 126 to the bias signal, the change-over signal may be output so that the signal output from the amplifier 144 may be selected with a shorter interval.

Moreover, the CPU 150 detects abnormality of the power-supply battery 160 based on the battery voltage data stored in the register 151. Furthermore, the CPU 150 detects abnormality of the power-supply battery 160 based on the battery temperature data stored in the register 152. Moreover, the CPU 150 adds the value of the received power input from the baseband-processing unit 104 and the value of the transmission power control data, to calculate target transmission power data, and outputs the transmission power control data to the ROM 127 and the ROM 129.

Here, in the W-CDMA type communication system, because the transmission power control data is input from the baseband-processing unit 104 every 0.625 mm seconds, the CPU 150 calculates the target transmission power data for each input of the transmission power control data. Furthermore, the CPU 150 outputs the value of the transmission frequency, which is notified from the baseband-processing unit 104, to the ROM 129. Additionally, the CPU 150 detects the generation of a call or receipt of a call that starts the transmission of the signal.

The ROM 127 stores the target transmission power data and the data of the signal to be provided to the variable gain amplifier 124, which correspond to each other, and outputs the data corresponding to the target transmission power data input from the CPU150. This data is converted to an analog signal by the digital/analog converter 128 and is output to the variable gain amplifier 124.

The ROM 129 stores the transmission frequency; the temperature data of the power amplifier 126; the target transmission power data; and the data specifying the most suitable gate bias signal that corresponds to each of the conditions of the transmission frequency, the temperature data, and the target transmission power data. In the present embodiment, the voltage data of the gate bias signal is used to specify the gate bias signal.

The ROM 129 also outputs the voltage data of the bias signal that corresponds to each of the transmission frequency, the target transmission power data input from the CPU 150, and the amplifier temperature data input from the register 153. The voltage data is converted to an analog signal by the digital/analog converter 130 and is output to the power amplifier 126 as a bias signal. Therefore, a bias signal suitable for the transmission frequency is provided to the power amplifier 126 so that the efficiency of the power amplifier 126 increases.

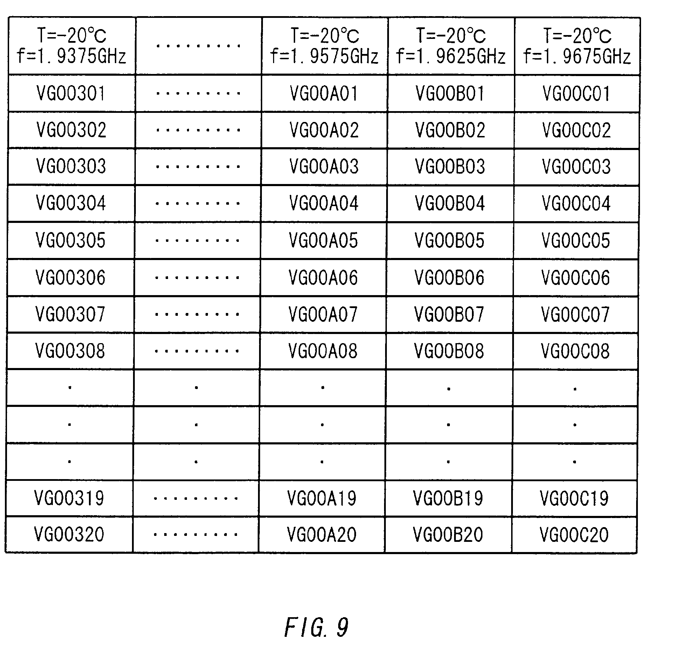

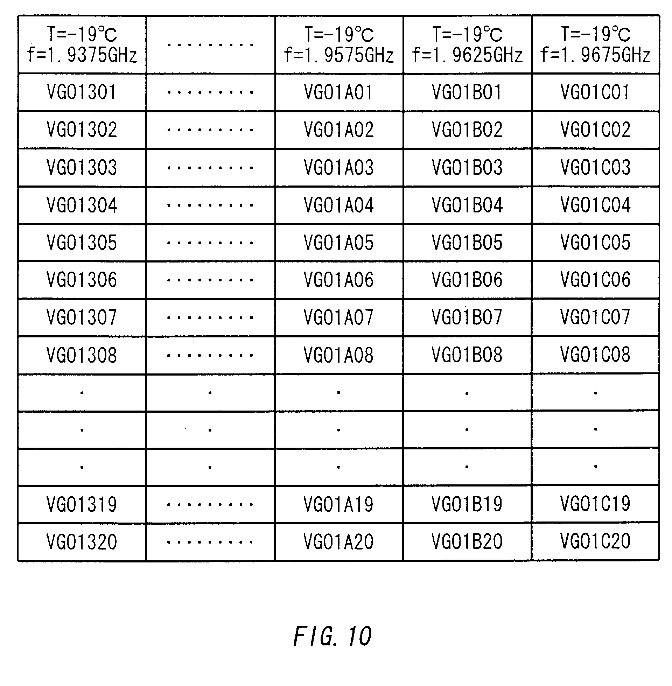

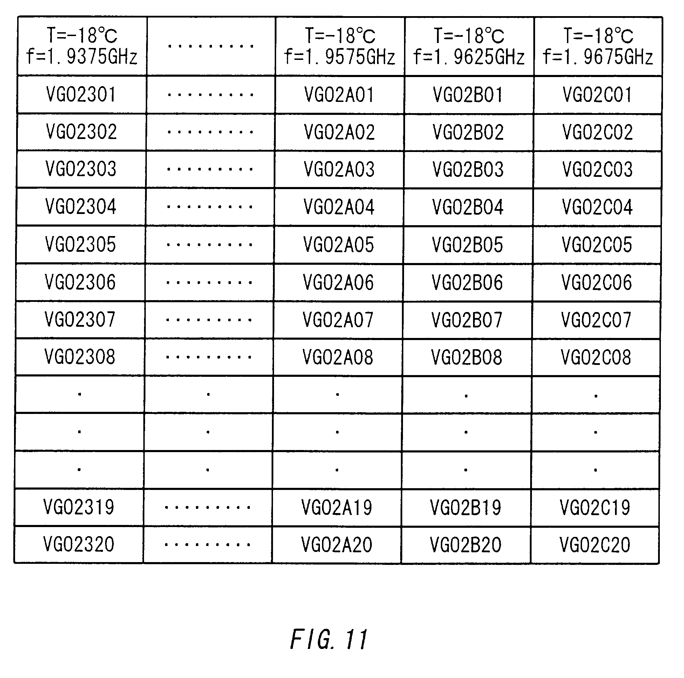

Fig. 9, Fig. 10, and Fig. 11 show an outline of the storing condition of the ROM 129 according to the first embodiment of the present invention. Fig. 9 shows a storing condition of the voltage data of the bias signal when the temperature of the power amplifier 126 is - 20 degrees. Fig. 10 shows a storing condition of the voltage data of the bias signal when the temperature of the power amplifier 126 is - 19 degrees. Fig. 11 shows a storing condition of the voltage data of the bias signal when the temperature of the power amplifier 126 is - 18 degrees.

As shown from Fig. 9 to Fig. 11, the ROM 129 has columns for each temperature and the transmission frequency of the power amplifier 126. The voltage data of each bias signal, each of which corresponds to the target transmission power data, is stored in each of the columns. The characters having seven-digit numbers shown in Fig. 9 to Fig. 11 are the index for indicating the stored voltage data. For example, in the VG01A06 shown in Fig. 10, the "01", which is the third and forth digit from the left, indicates a temperature. The "A", which is the fifth digit from the left, indicates a transmission frequency. The "06", which is the sixth and seventh digit from the left, indicates a target transmission power data.

Next, the mobile station according to the second embodiment will be explained. Because the mobile station according to the second embodiment has a same hardware construction as the mobile station 100 according to the first embodiment shown in Fig. 4, the explanation for the hardware will be omitted here. The operation such as controlling the change-over signal by the CPU 150 in the mobile station according to the present embodiment is the main difference from the operation in the mobile station 100 according to the first embodiment. Here, the same reference numerals will be used for the hardware which is same as the hardware shown in Fig. 4, in the explanation for the mobile station according to the present embodiment.

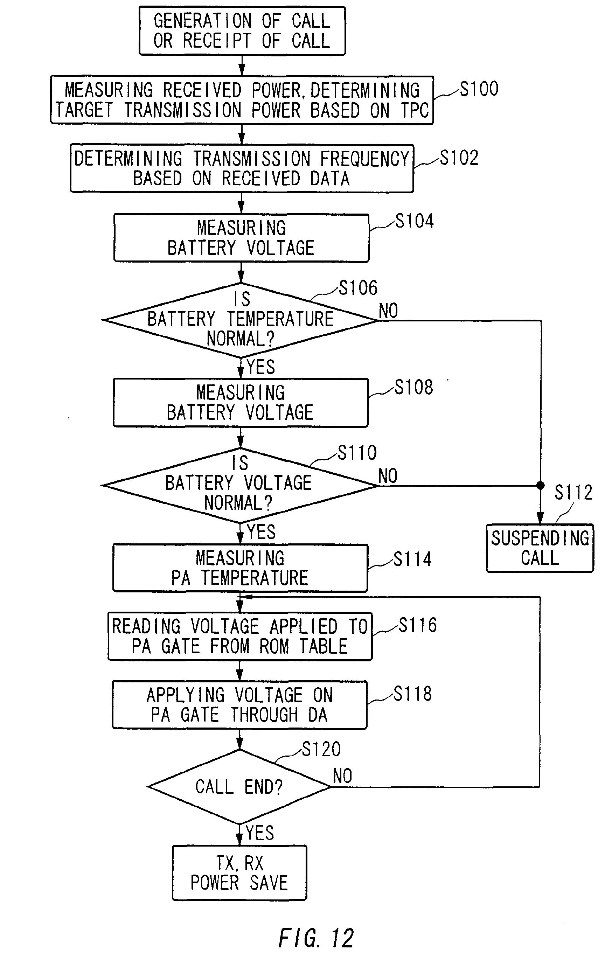

Fig. 12 shows a flow chart that explains the operation of the mobile station according to the second embodiment of the present invention. First, when the CPU 150 detects that a call is generated, or a call is received, the target transmission power data is determined by adding the received power level input from the baseband-processing unit 104 and the transmission power control (TPC) data (S100). Next, the transmission frequency is determined based on the data output from the baseband-processing unit 104 (S102).

The CPU 150 then outputs the change-over signal to the change-over unit 145 so that the change-over unit 145 selects the signal output from the amplifier 143. The CPU 150 also outputs the change-over signal to the change-over unit 147 so that the data input from the amplifier 143 flows to the register 152. Thereby the signal related to the temperature of the power-supply battery 160 detected by the temperature sensor 141 is converted toadigital signal bytheanalog/digital converter 146tobebattery temperature data, and stored to the register 152 (S104). Next, the CPU 150 takes out the battery temperature data of the power-supply battery 160 from the register 152 and judges whether the temperature in the battery temperature data is a normal temperature for the power-supply battery 160 (S106). If the temperature is abnormal according to this judgment, the calling process will be suspended (S112).

On the other hand, if the temperature is normal, the CPU 150 outputs the change-over signal to the change-over unit 145 so that the change-over unit 145 selects the signal output from the amplifier 142. The CPU 150 also outputs the change-over signal to the change-over unit 147 so that the data input from the amplifier 142 flows to the register 151. Thereby, the signal related to thevoltage of the power-supply battery 160 is converted to adigital signal by the analog/digital converter146, and the data related to the voltage of the power-supply battery 160 is stored to the register 151 (S108). The CPU 150 then inputs the data related to the voltage of the power-supply battery 160 from the register 151 and judges whether the voltage in the data is normal as a voltage of the power-supply battery 160 (S110). The calling process will be suspended if the voltage of the power-supply battery is abnormal according to the judgment (S110).

If the voltage of the power-supply battery is normal, the CPU 150 outputs the change-over signal to the change-over unit 145 so that the change-over unit selects the signal output from the amplifier 144. The CPU 150 also outputs the change-over signal to the change-over unit 147 so that the data input from the amplifier 144 flows to the register 153. Thereby the signal related to the temperature of the power amplifier 126 is converted to the amplifier temperature data, which is a digital signal, by the analog/digital converter 146 and stored to the register 153 (S114).

The CPU 150 then outputs the target transmission power data and the value of the transmission frequency output from the baseband-processing unit 104 to the ROM 129. Furthermore, the register 153 outputs the amplifier temperature data to the ROM 129. The ROM 129 reads the voltage data of the bias signal corresponding to the target transmission power data, the value of the transmission frequency, and the amplifier temperature data from the ROM table in ROM 129 as shown in Fig. 9 to Fig. 11 (S116). This voltage data of the bias signal will be applied to the gate of the power amplifier 126. Next, the digital/analog converter 130 converts the voltage data to an analog signal and outputs the converted voltage data to the power amplifier 126 (S118). Thereby, the voltage data of the bias signal is applied to the gate of the power amplifier 126 through the digital/analog converter 130. Therefore, the power amplifier 126 amplifies the signal efficiently.

The above process from the step S116 to the step S118 is performed repeatedly until the end of the call. The process of suppressing the power consumption of the transmitting unit106 and the receiving unit 108 is performed when the call ends (S122). Here, generally, each device that constitutes the transmitting unit 106 and the receiving unit 108 has a function of suppressing the power consumption. The function of controlling the power consumption can be performed by turning on the power save (PS) terminal, which is provided on the device. As explained above, in the present embodiment, because the CPU 150 outputs the change-over signal to the change-over unit 145 and 147 only when a call is generated or a call is received, the power consumption can be reduced.

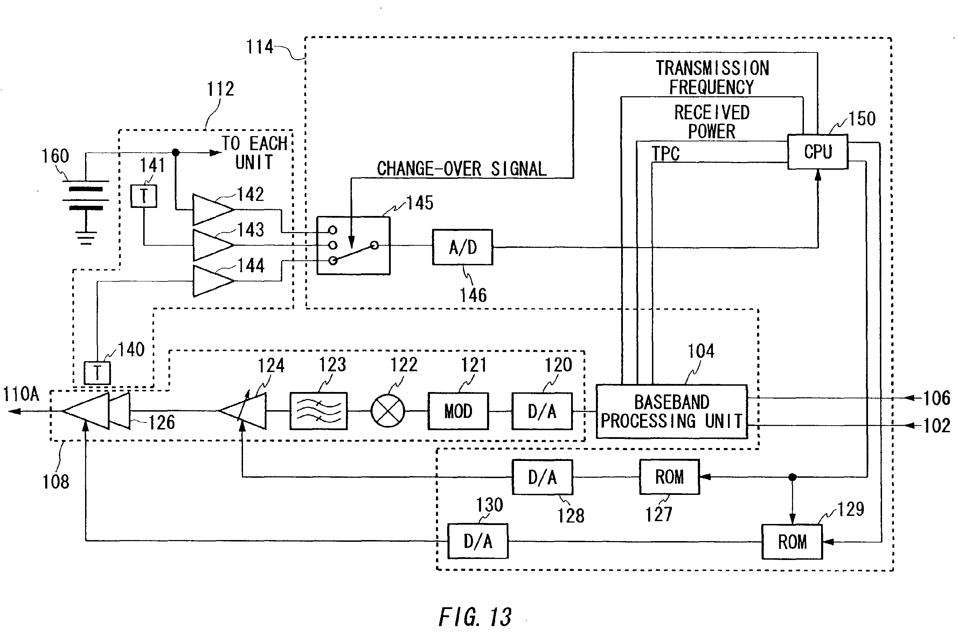

Fig. 13 shows a part of a configuration of a mobile station according to the third embodiment of the present invention. The mobile station according to the third embodiment has a configuration that removes the change-over unit 147 and the registers 151, 152, and 153 from the mobile station 100 according to the first embodiment shown in Fig. 4. The function of the CPU 150 of the mobile station 100 of the first embodiment is modified in the mobile station of the third embodiment.

The CPU 150 outputs the change-over signal to the change-over unit 145, in order to make the change-over unit 145 select the necessary data. Furthermore, the CPU 150 detects abnormality of the power-supply battery 160 based on the battery voltage data output from the analog/digital converter 146. Additionally, the CPU 150 detects abnormality of the power-supply battery 160 based on the battery voltage data of the power-supply battery 160 output from the analog/digital converter 146. The CPU 150 also outputs to the ROM 127 and the ROM 129, the target transmission power data, which is obtained by adding the value of the received power input from the baseband-processing unit 104 and the value of the transmission power control data.

Furthermore, the CPU 150 outputs the value of the transmission frequency, which is input from the baseband-processing unit 104, to the ROM 129. Moreover, the CPU 150 outputs the amplifier temperature data, which is output from the analog/digital converter 146, to the ROM 127 and the ROM 129. According to the above configuration, the mobile station does not need to comprise the change-over unit 147 and the registers 151, 152, and 153, so that the configuration of the mobile station can be simplified, and the cost for manufacturing the mobile station can be reduced.

This invention is not limited to the above embodiments, and various modification can be applied on the above embodiments. For example, in the above embodiments, the bias signal is output based on the transmission frequency in the mobile station 100. However, the present invention is not limited to the above embodiments, andthe bias signal can be output based on the transmission frequency in the base station 200. Moreover, in the above embodiments, the digital bias signal is output from the analog/digital converter 146 by changing over a plurality of temperature sensors and analog signals in the mobile station 100. However, the present invention is not limited to the above embodiments, and the bias signal can be output from the analog/digital converter 146 by changing over a plurality of temperature sensors and analog signals in the base station 200.

Moreover, in the above embodiments, the change-over unit 145 selects one of the analog signals from the three analog signals. However, the present invention is not limited to the above embodiments, and two analog signals can be selected from the three analog signals, for example. The point is, to select a reduced number of the analog signals. Thereby the number of necessary analog/digital converters can be reduced, the cost for manufacturing the mobile station can be reduced, and also the size of the mobile station can be reduced. Moreover, the power consumption of the mobile station can be reduced.

Although the present invention has been described by way of exemplary embodiments, it should be understood that many changes and substitutions may be made by those skilled in the art without departing from the spirit and the scope of the present invention which is defined only by the appended claims.

## Claims

1. A transmitter for transmitting a transmission signal, which is an object to be transmitted, by radio transmission comprising:
a plurality of analog signal output units (140, 141), each of which outputs an analog signal based on a predetermined condition of said transmitter;
characterized in that an analog signal selecting unit (145) that selects at least one of said plurality of said analog signals output from said plurality of analog signal output units (140, 141); and an analog/digital converter (146) that converts said at least one of analog signals selected by said analog signal selecting unit (145), to a digital signal.

2. A transmitter as claimed in claim 1, characterized in that said transmitter further comprises: a power amplifier (108) that amplifies said transmission signal based on a bias signal, which adjusts a power of said transmission signal; wherein one of said analog signal output units (140) outputs said analog signal based on a temperature of said power amplifier (108); said analog/digital converter (145) converts said analog signal, which is output based on said temperature of said power amplifier (108), to said digital signal; and a bias signal output unit (129) that outputs said bias signal based on at least one of said digital signal, power control data that determines a target power to which a power of said transmission signal is to be amplified, and a transmission frequency for transmitting said transmission signal.

3. A transmitter as claimed in claim 2, characterized in that said bias signal output unit (129) stores said bias signal, which corresponds to each of said digital signals, said transmission frequency, and said power control data, and outputs said bias signal based on at least one of said digital signal, said transmission frequency, and said power control data.

4. A transmitter as claimed in claim 2, characterized in that said transmitter further comprises: a register (153) that stores said digital signal converted from said analog signal by said analog/digital converter (146), which is output based on said temperature of said power amplifier (126) ; wherein saidbias signal output unit (129) outputs said bias signal based on said digital signal stored in said register (153).

5. A transmitter as claimed in claim 1, characterized in that said analog signal selecting unit (145) selects said analog signal from said plurality of said analog signals one after another, at a predetermined time interval.

6. A transmitter as claimed in claim 1, characterized in that said transmitter further comprises: a battery (160) for supplying power; a power amplifier (126) that amplifies said transmission signal based on a bias signal, which adjusts power of said transmission signal; wherein: one of said analog signal output units (142) outputs said analog signal based on a voltage of said battery (160); said analog/digital converter (146) converts said analog signal, which is output based on said voltage of said battery (160), to said digital signal; and an abnormality detector (150) which detects abnormality (106) of said battery based on said digital signal, when said voltage of said battery (106) is out of a permissible range.

7. A transmitter as claimed in claim 6, characterized in that said transmitter further comprises: a register (151) that stores said digital signal converted from said analog signal, which is output based on said voltage of said battery (160), by said analog/digital converter (146) ; wherein saidabnormalitydetector (150) detects said abnormality of said battery (160) based on said digital signal stored in said register (151).

8. A transmitter as claimed in claim 1, characterized in that said transmitter further comprises: a battery (160) for supplying power; a power amplifier (126) that amplifies said transmission signal based on a bias signal, which adjusts power of said transmission signal; wherein: one of said analog signal output units (141) outputs said analog signal based on a temperature of said battery (160); said analog/digital converter (145) converts said analog signal, which is output based on said temperature of said battery (160), to said digital signal; and an abnormality detector (150) which detects abnormality of said battery (160) based on said digital signal, when said temperature of said battery (160) is out of a permissible range.

9. A transmitter as claimed in claim 8, characterized in that said transmitter further comprises: a register (152) which stores said digital signal converted from said analog signal, which is output based on said temperature of said battery (160), by said analog/digital converter (146) ; wherein said abnormality detector (150) detects said abnormality of said battery (160) based on said digital signal stored in said register (152).

10. Amobile station for a radio communication system comprising:
an antenna (110) which receives and transmits a signal; a receiving unit (106) which converts a frequency of said signal received by said antenna (110) to a predetermined intermediate frequency; a baseband processing unit (104) which demodulates said signal input from said receiving unit (106) to obtain data contained in said signal and modulates a transmission signal, which is a signal to be transmitted; an input/output unit (102) which outputs said data obtained by said baseband processing unit (104) and inputs data from outside, which is to be transmitted, to output said transmission signal to said baseband processing unit (104) ;
a plurality of analog signal output units (140, 141), each of which outputs an analog signal based on a predetermined condition of said mobile station (100);
characterized in that: an analog signal selecting unit (145) that selects at least one of said plurality of said analog signals output from said plurality of analog signal output units (140, 141) ; ananalog/digital converter (146) that converts said at least one of analog signals, which is selected by said analog signal selecting unit (145), to a digital signal; and a transmitting unit (108) which converts a frequency of said transmission signal modulated by said baseband processing unit (104) to a predetermined frequency, and outputs said transmission signal to said antenna (110) based on said digital signal converted by said analog/digital converter (146).

11. A mobile station as claimed in claim 10, characterized in that: saidtransmittingunit (108) includes a power amplifier (126) that amplifies said transmission signal based on a bias signal, which adjusts a power of said transmission signal; and one of said analog signal outputs unit (140) outputs said analog signal based on a temperature of said power amplifier (126); and said analog/digital converter (146) converts said analog signal, which is output based on said temperature of said power amplifier (126), to said digital signal; and said mobile station further comprises a bias signal output unit (129) that outputs said bias signal based on at least one of said digital signal, power control data that determines a target power to which a power of said transmission signal is to be amplified, and a transmission frequency for transmitting said transmission signal.

12. A mobile station as claimed in claim 10, characterized in that said analog signal selecting unit (145) selects said analog signal from said plurality of said analog signals one after another, at a predetermined time interval.

13. A method for transmitting a transmission signal, which is an object to be transmitted, by radio transmission including: outputting a plurality of analog signals based on a predetermined condition of transmitting said transmission signal;
characterized in that selecting at least one of said plurality of analog signals output by said outputting; and converting at least one of said analog signals, which is selected by said selecting, to a digital signal.

14. A method as claimed in claim 13, characterized in that said method further includes: amplifying said transmission signal based on a bias signal, which adjusts a power of said transmission signal;
wherein: said outputting outputs said analog signal based on a temperature caused by said amplifying; said converting converts said analog signal, which is output based on said temperature, to said digital signal; and outputting said bias signal based on at least one of said digital signal, power control data that determines a target power to which a power of said transmission signal is amplified, and a transmission frequency for transmitting said transmission signal.

15. A method as claimed in claim 14, characterized in that said method further includes: storing said digital signal converted from said analog signal, which is output based on said temperature caused by said amplifying; wherein said outputting said bias signal outputs said bias signal based on said digital signal stored by said storing.

16. A method as claimed in claim 13, characterized in that said selecting selects said analog signal from said plurality of said analog signals one after another, at a predetermined time interval.

17. A method as claimed in claim 13, characterized in that said method further includes: supplying power from a battery (160) ; amplifying said transmission signal based on a bias signal, which adjusts a power of said transmission signal; wherein: said outputting outputs said analog signal based on a voltage of said battery (160), and said converting converts said analog signal, which is output based on said voltage of said battery (160), to said digital signal; and detecting abnormality of said battery (160) based on said digital signal when said voltage of said battery (160), is out of a permissible range.

18. A method as claimed in claim 17, characterized in that said method further includes: storing said digital signal converted from said analog signal, which is output based on said voltage of said battery (160); wherein: said detecting detects said abnormality of said battery (160) based on said digital signal stored by said storing.

19. A method as claimed in claim 13, characterized in that said method further includes: supplying power from a battery (160); amplifying said transmission signal based on a bias signal, which adjustspowerof saidtransmissionsignal; wherein: saidoutputting outputs said analog signal based on a temperature of said battery (160), and said converting converts said analog signal, which is output based on said temperature of said battery (160), to said digital signal; and detecting abnormality of said battery (160) based on said digital signal when said temperature of said battery (160) is out of a permissible range.

20. A method as claimed in claim 19, characterized in that said method further includes: storing said digital signal converted from said analog signal, which is output based on said temperature of said battery (160); wherein said detecting detects said abnormality of said battery (160) based on said digital signal stored by said storing.
